# EUROPEAN PATENT APPLICATION

(11) **EP 3 364 505 A1**
(43) Date of publication of application: **22.08.2018**
(21) Application number: 17156838.9
(22) Date of filing: 20.02.2017
(51) Int. Cl.: H01R 13/62, G01R 33/02, G01R 33/04

(54) **QUICK FIT CONNECTION ASSEMBLY AND METHOD FOR TESTING CORRECT FITTING**

(71) Applicant: Ford Otomotiv Sanayi Anonim Sirketi, 34885 Istanbul (TR)
(72) Inventor: Ölmez, Halil, Degirmendere/Kocaeli (TR); Koç, Tamer, 59850 Çorlu / Tekirdag (TR); Yurt, Nehir, izmit/kocaeli (TR); Yildiz, Muharrem, 41650 Gölcük Kocaeli (TR); Karadeniz, Cihan, izmit/kocaeli (TR); Akpinar, Berk, Basiskele/kocaeli (TR); Akdag, Hüsniye, Körfez/Kocaeli (TR)
(74) Representative: Illing, Rolf

(57) **Abstract**

The present invention relates to an assembly (100) comprising a male and female quick-fit connector (111, 121), each comprising a ring-shaped magnet (112, 122), preferably magnetized in radial direction, and to a method (300) of detecting correct engagement of the male and female quick-fit connector by measuring the magnitude (M) of the magnetic field in the immediate vicinity of the second connector (121), and by comparing the measured magnitude (M) with a predefined threshold (Tr).

## Description

The present invention relates to a quick fit connection assembly comprising a male and a female connector, each of which comprises a magnet. The invention further relates to a method of testing whether the connectors are correctly fitted, in particular as a quality control test in an automotive production environment.

Quick fit connectors of various shapes and sizes are known in the art. They allow fast and easy connection of two objects, for example two cables or two tubes or two conduits, for example during assembly on a production line. During engagement, the operator typically inserts a male connector into a female connector by pushing until he/she hears a click noise, for example related to a metal-to-metal contact, or to a spring which is released, or the like.

When, at a later moment in time, a quality person wants to test correct engagement of the connector assembly, the quality person can typically only use visual inspection, which is not always reliable, and is subject to human errors.

As far as is known to the inventors, this problem is not satisfactory addressed in the field of quick-fit connectors without considerably complicating the design of the connectors and/or without considerably increasing the cost of the connectors, which is therefore not an economically viable solution for the automotive industry.

US 4,665,361 discloses a method and apparatus for the contactless determination of the relative positions of two bodies by passing an alternating current in the first body, establishing an alternating magnetic field around the body. Coil pairs are supported on a second body so as to essentially surround the first body, the coils being used to produce voltages proportional to the intensity of the magnetic field, thereby providing differential distance information.

US 5,581,179 discloses a magnetic-field sensor assembly comprising a preformed housing shell having a first end which includes an opening, and a second end which includes a window and having a cylindrical shape with a flattened portion to produce a truncated circular cross-section, a sensor package including an integrated-circuit magnetic field sensor chip encapsulated in a protective body with a plurality of integral conductive leads.

US 6,809,512 B2 discloses a pedal with integrated position sensor.

US 2007/273365 A1 discloses a Hall sensor arrangement and use of a hall sensor arrangement in a belt lock.

US 4,538,107 describes a cable failure detection system to detect changes in the magnetic field of a cable that has been magnetized said changes in the magnetic field coming about due to a flaw in said cable. Said changes are sensed by a gauss meter which generates a signal, said signal being converted into a visual or audio signal for early warning of failure.

EP 2 992 841 A2 discloses a surgical stapling system including a shaft assembly and an anvil movable between open and closed positions; the anvil having a magnet at a distal end, and a staple cartridge removably positioned within the channel. The system is capable of detecting whether the cartridge is misloaded, by making use of a Hall effect sensor located at the distal end of the cartridge body and a microprocessor.

US 8,094,017 B2 discloses an electromagnetic lock monitoring system for monitoring the strength of a magnetic field in an electromechanical lock which is created when a steel armature plate is closed against an electromagnet. The system utilizes dual Hall Effect devices positioned in such a way that both ends of the electromagnet and both magnetic fields are monitored.

There remains a need to provide a quick-fit connector assembly and a reliable method of testing correct engagement.

The present invention has the object to provide a quick-fit connector assembly comprising a male and female connector having provisions that allow to objectively evaluate correct connector engagement, and to provide a method of testing correct engagement of the male and female connector of such a connector assembly.

It is a particular object of the present invention to provide such an assembly and a method for evaluating correct engagement of the connectors of the assembly by a member of the quality control team in an automotive production environment in a more reliable manner, without significantly increasing the cost of the connectors.

These objects are achieved by an assembly having the features of claim 1, and by a method having the features of the independent method claim. Further, particularly advantageous embodiments of the invention are disclosed in the dependent claims.

It should be noted that the individual features listed in the description below can be combined in any technically meaningful way with each other and show further embodiments of the invention. The description of the invention is additionally characterized and specified particularly in connection with the figures.

In an advantageous embodiment, the present invention discloses an assembly comprising a first object having a male quick-fit connector comprising a first annular or ring-shaped magnet; a second object having a female quick-fit connector comprising a second annular or ring-shaped magnet; the male quick-fit connector being engaged with the female quick-fit connector in such a way that the first magnet and the second magnet are positioned concentrically.

It is an advantage of this assembly that both the male and female connectors have a magnet. This allows to test the relative position of the connectors by testing the relative position of the magnets. It is also an advantage that the magnets attract each other when connecting the two connectors.

It is a further advantage that this assembly does not need a sensor element to be integrated in the connectors and does not need electrical wires for reading out the sensor element.

It is an advantage of using two annular or ring-shaped magnets that only two such magnets are required rather than requiring a plurality of individual magnets and that these magnets can easily and accurately be mounted in the individual connectors.

It is an advantage of arranging the first magnet to the male connector, and the second magnet to the female connector in such a way that, when the male connector and female connector are correctly engaged, in particular in an axial direction, that the first and second magnet are positioned substantially concentrically, meaning that a centre of the first magnet substantially coincides with a centre of the second magnet. The inventors surprisingly found that in this position, the combined magnetic field created by the magnets has a lower value than when the magnitude encountered with the connectors are not correctly engaged. They further found that, by choosing a suitable threshold value, correct engagement of the connectors can be verified by measuring the magnetic field intensity around the second female connector and by comparing the measured intensity with the predefined threshold, depending on whether the measured value is smaller or larger than the threshold value.

According to a further advantageous embodiment of the present invention, the assembly is a sensor-less assembly, meaning for example that the connectors do not comprise an integrated Hall element.

It is an advantage of sensor-less connectors that they are easier and cheaper to produce and do not require electrical wires for biasing and for reading out the integrated Hall element.

According to a further advantageous embodiment of the present invention, the first magnet and the second magnet are permanent magnets.

Permanent magnets are widely available on industrial scale and at an economic cost and the magnetic field is generated without having to incorporate an electrical coil and wiring and a control system for energizing such a coil.

According to a further advantageous embodiment of the present invention, the first magnet and the second magnet are magnetized in a radial direction.

This is a particularly advantages arrangement. The total magnetic field can be measured by a Gauss-meter and does not require a differential measurement.

According to a further advantageous embodiment of the present invention, the first and second object is a tube.

According to a further advantageous embodiment of the present invention, the second object comprises a disconnect mechanism for disconnecting the male and female connector.

It is an advantage of such a disconnect mechanism that it allows easy separation of the first and second connectors after engagement, should that be necessary.

In another advantageous embodiment, the present invention discloses a kit of parts comprising the first object and the second object of the assembly described above.

The present invention discloses a method of testing correct engagement of the male and female connectors of a connector assembly, the method comprising the steps of: a) providing an assembly as described above; b) measuring a magnitude of the magnetic field in the immediate vicinity of the female connector; c) testing whether the measured magnitude is larger than a predefined threshold; and if the outcome of the test is true, providing a first signal to indicate an incorrect engagement; and if the outcome of the test is false, providing a second signal to indicate correct engagement.

It is an advantage of this method that it allows evaluation of correct engagement of the connectors based on a measurement, rather than on visual inspection only. In this way incorrect engagement can be detected, assembly errors and evaluation errors can be avoided, and production quality can be increased.

The method can of course also be used during assembly, allowing also deaf workers to perform the assembly, even though they cannot hear an engagement sound.

According to a further advantageous embodiment of the present invention, step a) comprises: providing a first object with a male quick-fit connector comprising a first annular or ring-shaped magnet; providing a second object with a female quick-fit connector comprising a second annular or ring-shaped magnet; inserting the male quick-fit connector into the female quick-fit connector.

According to a further advantageous embodiment of the present invention, step b) comprises measuring the magnitude of the magnetic field using a Gauss-meter or DC Magnetometer.

It is an advantage of using magnets incorporated in the connectors and an (external) Gauss-meter for evaluating correct engagement of the connectors, because in this way costs of the connectors are kept low. The Gauss-meter can be used for testing a large number of assemblies and can be reused in other projects.

According to a further advantageous embodiment of the present invention, step c) comprises providing a visual signal and/or rendering an audible signal corresponding to the outcome of the test.

It is an advantage of providing a visual and/or acoustic signal, because it provides a fast and convenient way to interpret the result of the measurement.

According to a further advantageous embodiment of the present invention, the visual signal is a green light signal in case the outcome of the test is false, meaning that the measured magnitude is not larger than the predefined threshold, indicative of correct engagement; and that the visual signal is a red light signal in case the outcome of the test is true, meaning that the measured magnitude is indeed larger than the predefined threshold, indicative of incorrect engagement.

Showing a red light or a green light allows very easy and intuitive interpretation of the result.

According to a further advantageous embodiment of the present invention, the audible signal is a first beep having a first frequency and a first duration in case the outcome of the test is false, indicative of correct engagement, and the audible signal is a second beep having a second frequency and a second duration in case the outcome of the test is true, indicative of incorrect engagement, wherein the ratio of the first and second frequency is lower than 0.75 or higher than 1.25 and/or wherein a ratio of the first and second duration is lower than 0.75 or higher than 1.25.

It is an advantage of using a short beep versus a long beep and/or a beep with a low tone versus a high tone to differentiate between a positive and negative outcome of the test, which can be easily recognized.

Further features and advantages of the present invention will become apparent from the following description of a non-limiting embodiment of the invention which will be explained below with reference to the drawing. In this drawing:
- FIG. 1(a): shows a first object having a male quick-fit connector in connective engagement with a second object having a female quick-fit connector;
- FIG. 1(b): shows the first and the second object of FIG. 1(a) after disengagement, located at a distance from each other for illustrative purposes. The male quick-fit connector has a first magnet and the second quick-fit connector has a second magnet;
- FIG. 2(a): shows the relative position of the first/second magnet of the male/female quick-fit connector of FIG. 1(a) in cross-sectional view in plane A-A, in correct engagement;
- FIG.2(b): shows the relative position of the first/second magnet of the male/female quick-fit connector of FIG. 1(a) in cross-sectional view in plane B-B, in correct engagement;
- FIG. 2(c): shows an example of the relative position of the first/second magnet of the male/female quick-fit connector of FIG. 1(a) in cross-sectional view in plane A-A, in case of incorrect engagement;
- FIG. 2(d): shows an example of the relative position of the first/second magnet of the male/female quick-fit connector of FIG. 1(a) in cross-sectional view in plane B-B, in case of incorrect engagement; and
- FIG. 3: shows a flow diagram of a method of the present invention for testing correct engagement of the male and female quick-fit connectors shown in FIG. 1(a).

The present invention is related to a quick-fit connection assembly comprising a male and a female connector, each of which comprises a magnet, preferably an annular or a ring-shaped magnet. The present invention is also related to parts comprising objects having such a male and female connector. The present invention is also related to a method of testing whether the connectors of such an assembly are correctly engaged. The method is particularly suitable as a quality control test in an automotive production environment.

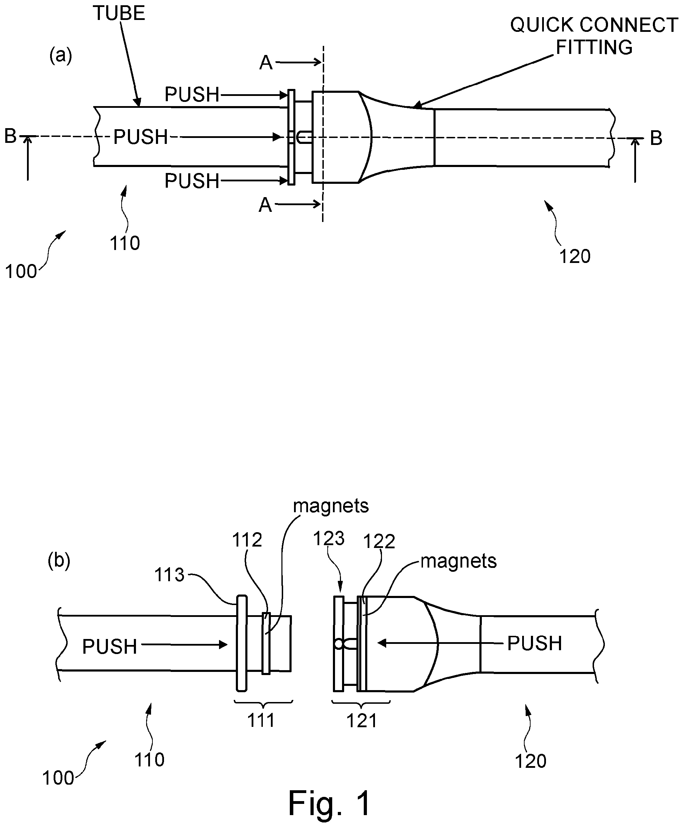

FIG. 1 shows an example of an assembly 100 according to the present invention, comprising a first object, for example a cable or tube or conduit 110 and a second object, for example a cable or tube or conduit 120. FIG. 1(a) shows the first object and second object when engaged. FIG. 1(b) shows the first object and the second object when disengaged or released. The first object 110 has a male quick-fit connector 111 comprising a first magnet 112. The second object 120 has a mating female quick-fit connector 121 comprising a second magnet 122, and optionally further comprises a disconnect mechanism 123. First magnet 112 is preferably an annular or ring-shaped magnet and is preferably located at an outer surface of the first object. The second magnet 122 is preferably an annular or ring-shaped magnet and is preferably located at an inner surface of the second object. The second magnet is shown as a thick line in FIG. 1(b) for illustrative purposes, but in reality may not be visible from the outside. The female connector 121 has an opening (not visible in FIG. 1 adapted for receiving a portion of the male connector 111. An outer diameter of the first magnet 112 is smaller than an inner diameter of the second magnet 122. The first object 110 or the male connector 111 may further comprise a rim 113 to facilitate pushing the first connector 111 into the second connector 121 during engagement.

As can be appreciated from FIG. 1(a) it is not easy by visual inspection to assess whether the first connector 111 and the second connector 121 are correctly engaged.

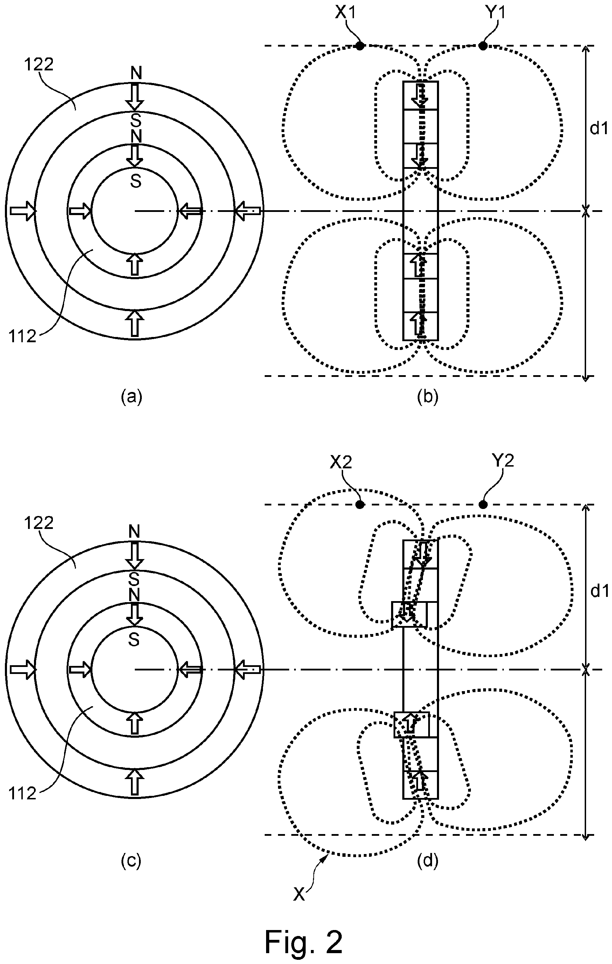

FIG. 2(a) and FIG. 2(b) show the relative positions of the magnets when the first connector is correctly engaged with the second connector.

FIG. 2(a) shows the relative position of the first/second magnets 112, 122 of the male/female quick-fit connectors 111, 121 of FIG. 1(a) in cross-sectional view in plane A-A, when the first and the second connectors 111, 121 are correctly engaged. It is noted that FIG. 2(a) only shows the magnets 112, 122, but does not show other material of the first and second objects 110, 120, for example forming a cable or tube or the like. In practice there is a small distance or spacing or gap between the inner diameter of the second magnet 122 and the outer diameter of the first magnet 112, but the drawing is not drawn to scale for illustrative purposes. As can be seen, the first and second magnet 112, 122 are arranged concentrically during engagement.

FIG. 2(b) shows the relative position of the first/second magnets 112, 122 of the male/female quick-fit connectors 111, 121 of FIG. 1(a) in cross-sectional view in plane B-B, when the connectors 111, 121 are in correct engagement. As can be seen, the magnets are located substantially in the same "plane" perpendicular to the longitudinal axis of the first object 110 and second object 120. This means that the first and second magnets 112, 122 essentially have the same midpoint or center of gravity when the male/female quick-fit connectors 111, 121 are engaged correctly.

Exemplary magnetic field lines are shown, which may help to explain and understand how the present invention works, but the inventors do not wish to be bound by any theory and these sketched field lines may not be entirely correct. As can be appreciated however, the magnitude or intensity of the magnetic field at location "X1" or "Y1" at a distance "d1" from the axis of the first/second connectors 111, 121 is a value, which is lower than a predefined threshold value. A suitable threshold value can be found experimentally and some margin can be added.

FIG. 2(c) and FIG. 2(d) show an example of the relative positions of the magnets 112, 122 when the first connector 111 is not correctly engaged with the second connector 121.

FIG. 2(c) is identical to FIG. 2(a), even when the male connector 111 is not completely inserted into the female connector 121.

FIG. 2(d) shows an example of the relative position of the first/second magnets 112, 122 of the male/female quick-fit connectors 111, 121 of FIG. 1(a) in cross-sectional view in plane B-B in case of incorrect or incomplete engagement.

As can be seen, the plane defined by the first magnet ring 112, in particular its midpoint or center of gravity, is offset in axial direction from the plane defined by the second magnet ring 122, in particular its midpoint or centre of gravity. This offset causes a measurable disturbance of the magnetic field. As can be appreciated by comparison of FIG. 2(d) and FIG. 2(b), the magnitude of the magnetic field at the location X2 is higher than the magnitude at the corresponding location X1 in FIG. 2(b), and the magnitude at the location Y2 is smaller than the magnitude at the corresponding location Y1 of FIG. 2(b).

From the above it can be understood that, by measurement of a magnitude of the magnetic field at locations in close vicinity to the second magnet 122, for example by contacting an outer surface of the second connector 121 with a Gauss-meter or with a probe capable of measuring a DC magnetic field or the like, and by testing whether the measured value is higher than the predefined threshold, it can be detected whether the first and second magnet are aligned or not, more specifically, are located in the same plane or not, which means that the male connector 111 and the female connector 121 are correctly engaged or not.

In the examples shown in FIG. 2(a)-(d), the magnetic field is oriented radially inwards, but that is not absolutely required, and the magnetic field could also be oriented radially outwards. It is advantageous however that the magnetic field of the outer magnet 122 and the magnetic field of the inner magnet 112 are both oriented radially inwardly or outwardly, such that the magnets attract each other, which helps to provide a quick-fit connection.

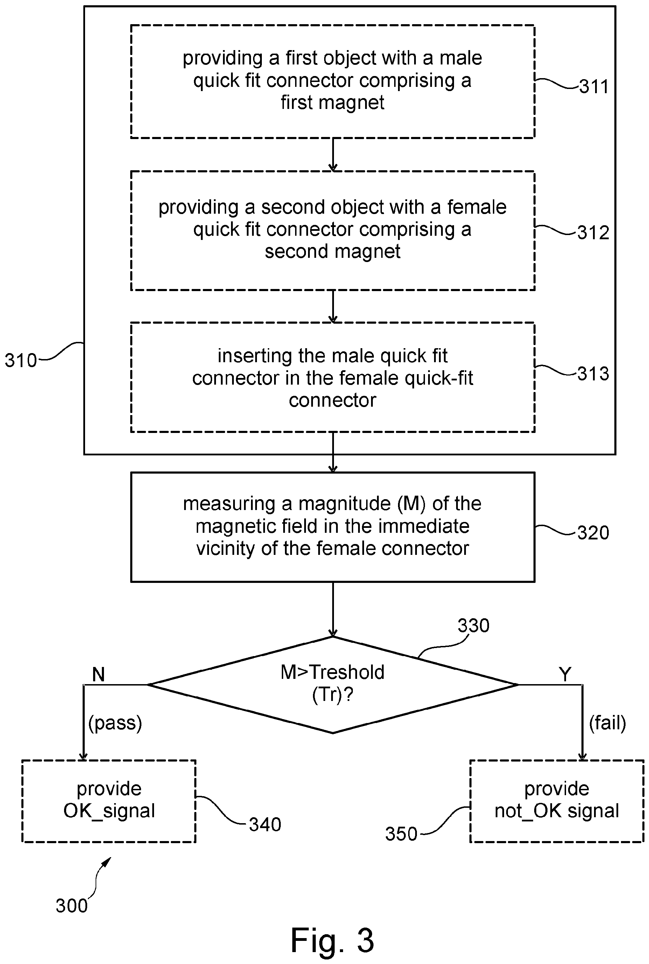

FIG. 3 shows a flow diagram of a method of the present invention for testing correct engagement of the male and female quick-fit connectors 111, 121 shown in FIG. 1. The method comprises the steps of:
a) providing 310 an assembly as described and illustrated above;
b) measuring 320 a magnitude M of the magnetic field in the immediate vicinity of the female connector 121;
c) testing 330 whether the measured magnitude M is larger than a predefined threshold Tr, and if the outcome of the test is true, meaning M>Tr, providing a first signal "not_OK" to indicate an incorrect engagement, and if the outcome of the test is false, meaning M<Tr, providing a second signal "OK" to indicate correct engagement.

The magnitude M of the magnetic field can for example be measured by making use of a Gauss-meter or a DC Magnetometer.

As described and illustrated above step a) comprise:
- providing 311 a first object 110 with a male quick-fit connector 111 comprising a first annular or ring-shaped magnet 112;
- providing 312 a second object 120 with a female quick-fit connector 121 comprising a second annular or ring-shaped magnet 122;
- inserting 313 the male quick-fit connector 111 into the female quick-fit connector 121.

Step c) may further comprise providing a visual signal, such as for example showing a red light to indicate "not OK", or a green light to indicate "OK". Additionally or alternatively step c) may comprise rendering an audible signal, such as rendering a relatively short beep at a relatively low frequency to indicate "not OK", or rendering a relatively long beep at a relatively higher frequency to indicate "OK". Such light signal or acoustic signal is faster and often more convenient to interpret.

The method is ideally suited for quality control of quick-fit connections in a production environment.

### REFERENCE NUMERALS

- 100: Assembly
- 110: First object
- 111: Male quick-fit connector
- 112: First magnet
- 113: Rim
- 120: Second object
- 121: Female quick-fit connector
- 122: Second magnet
- 123: Disconnect mechanism
- d1: Distance
- M: Magnitude of magnetic field
- Tr: Threshold

## Claims

1. An assembly (100) comprising:
- a first object (110) having a male quick-fit connector (111) comprising a first annular or ring-shaped magnet (112);
- a second object (120) having a female quick-fit connector (121) comprising a second annular or ring-shaped magnet (122);
- the male quick-fit connector (111, 121) being engaged with the female quick-fit connector in such a way that the first magnet (112) and the second magnet (122) are positioned concentrically.

2. An assembly according to claim 1, wherein the assembly is a sensor-less assembly.

3. An assembly according to claim 1 or 2, wherein the first magnet (112) and the second magnet (122) are permanent magnets.

4. An assembly according to any of the previous claims, wherein the first magnet (112) and the second magnet (122) are magnetized in a radial direction.

5. An assembly according to any of the previous claims, wherein the first and second object (110, 120) is a tube.

6. An assembly according to any of the previous claims, wherein the second object comprises a disconnect mechanism (123) for disconnecting the male and female connectors (111, 121).

7. An assembly according to any of the previous claims, wherein an outer diameter of the first magnet (112) is smaller than an inner diameter of the second magnet (122).

8. A kit of parts comprising the first object (110) and the second object (120) of the assembly (100) according to any of the claims 1 to 7.

9. A method of testing correct engagement of male and female connectors (111, 121) of a connector assembly (100), the method comprising at least the steps of:
a) providing (310) an assembly (100) according to any of the claims 1 to 7;
b) measuring (320) a magnitude (M) of the magnetic field in the immediate vicinity of the female connector (121);
c) testing (330) whether the measured magnitude (M) is larger than a predefined threshold; and if the outcome of the test is true, providing a first signal (not_OK) to indicate an incorrect engagement; and if the outcome of the test is false, providing a second signal (OK) to indicate correct engagement.

10. A method according to claim 9, wherein step a) comprises:
- providing (311) a first object (110) with a male quick-fit connector (111) comprising a first annular or ring-shaped magnet (112);
- providing (312) a second object (120) with a female quick-fit connector (121) comprising a second annular or ring-shaped magnet (122);
- inserting (313) the male quick-fit connector (111) into the female quick-fit connector (121).

11. A method according to claim 9 or claim 10, wherein step b) comprises measuring the magnitude (M) of the magnetic field using a Gauss-meter or DC Magnetometer.

12. A method according to any of the claims 9 to 11, wherein step c) comprises providing a visual signal and/or rendering an audible signal corresponding to the outcome of the test.

13. A method according to claim 12, wherein the visual signal is a green light signal in case the outcome of the test is false, indicative of correct engagement; and wherein the visual signal is a red light signal in case the outcome of the test is true, indicative of incorrect engagement.

14. A method according to claim 12 or 13, wherein the audible signal is a first beep having a first frequency and a first duration in case the outcome of the test is false, indicative of correct engagement; and wherein the audible signal is a second beep having a second frequency and a second duration in case the outcome of the test is true, indicative of incorrect engagement; and wherein a ratio of the first and second frequency is lower than 0.75 or higher than 1.25 and/or wherein a ratio of the first and second duration is lower than 0.75 or higher than 1.25.
